# EUROPÄISCHE PATENTANMELDUNG

(11) **EP 1 335 452 A2**
(43) Veröffentlichungstag der Anmeldung: **13.08.2003**
(21) Anmeldenummer: 03000900.5
(22) Anmeldetag: 16.01.2003
(51) Int. Cl.: H01R 4/02

(54) **Verfahren zur elektrischen Kontaktierung zweier Metallstrukturen**

(30) Priorität: 08.02.2002 DE 10205521
(71) Anmelder: W.C. Heraeus GmbH & Co. KG, 63450 Hanau (DE)
(72) Erfinder: Bauer, Alfred, 63755 Alzenau (DE); Hartmann, Horst, 63454 Hanau (DE); Kolodzei, Günter, 63791 Karlstein (DE); Rabe, Michael, 63486 Bruchköbel (DE)
(74) Vertreter: Kühn, Hans-Christian

(57) **Zusammenfassung**

Die Erfindung betrifft ein Verfahren zur elektrischen Kontaktierung zweier Metallstrukturen, wobei mindestens eine der Metallstrukturen auf ihrer der zweiten Metallstruktur zugewandten Seite aus einer Ebene herausragende Kontaktzonen aufweist, wobei zwischen den Metallstrukturen eine elektrisch isolierende Schicht angeordnet wird, wobei eine Metallstruktur mit der elektrisch isolierenden Schicht laminiert wird und danach oder gleichzeitig die zweite Metallstruktur mit der elektrisch isolierenden Schicht laminiert wird und wobei während des Laminierens der zweiten Metallstruktur mit der elektrisch isolierenden Schicht eine elektrische Kontaktierung zwischen den beiden Metallstrukturen erfolgt.

## Beschreibung

Die Erfindung betrifft ein Verfahren zum Kontaktieren von leitenden Schichten eines Metall-Kunststoff-Laminats.

Aus DE 198 52 832 ist ein Verfahren zur Herstellung eines Metall-Kunststoff-Laminats bekannt bei dem zunächst mindestens eine Metallfolie an mindestens einer Kunststofffolie angeheftet, beispielsweise geklebt, wird, die Metallfolie durch Prägen und/oder Tiefziehen mindestens einer Metallkontaktfläche geformt und anschließend die Metallfolie unter Erhaltung (nahezu) des Metallkontaktflächenprofils mit mindestens der einen Kunststofffolie laminiert wird. Ferner wird dort beschrieben, mindestens eine Metallfolie durch Prägen und/oder Tiefziehen mindestens einer Metallkontaktfläche zu formen und die Metallfolie mit mindestens einer Kunststofffolie so zu laminieren, dass das Metallkontaktflächenprofil der Metallfolie nahezu erhalten bleibt, wobei die mindestens eine Metallkontaktfläche nach der Laminierung eine Oberflächenprofilhöhe von 20 bis 50 µm aufweist.

Es wurde nun gefunden, dass sich die leitenden Schichten des Laminats in einem Arbeitsgang mit dem Laminieren an den gewünschten Stellen kontaktieren lassen. Dazu werden entweder in der isolierenden Schicht an den zu kontaktierenden Stellen Ausnehmungen vorgesehen oder die geprägten Erhebungen auf der Metallschicht durchstoßen oder verdrängen die - bei den herrschenden Temperaturen ohnehin weiche - Isolierschicht, so dass ein Kontakt hergestellt werden kann, z.B. durch Schweißen, Löten, Druck, Crimpen, Nieten, Bonden, Sintern, Reaktionsschweißen oder Reaktionsfügen.

Man geht dabei so vor, dass mindestens eine geprägte Metallkontaktfläche eingesetzt wird. Das Prägen selbst erfolgt mit aus dem Stand der Technik bekannten Verfahren und Werkzeugen, beispielsweise durch einstellbare Präzisionsprägestempel. Die Oberflächenprofilierung der Metallfolie erfolgt nach den jeweiligen erforderlichen elektrischen Gegebenheiten.

Die Erfindung betrifft somit ein Verfahren zur elektrischen Kontaktierung zweier Metallstrukturen, wobei mindestens eine der Metallstrukturen auf ihrer der zweiten Metallstruktur zugewandten Seite aus einer Ebene herausragende Kontaktzonen aufweist, wobei zwischen den Metallstrukturen eine elektrisch isolierende Schicht angeordnet wird, wobei eine Metallstruktur mit der elektrisch isolierenden Schicht laminiert wird und danach oder gleichzeitig die zweite Metallstruktur mit der elektrisch isolierenden Schicht laminiert wird und wobei während des Laminierens der zweiten Metallstruktur mit der elektrisch isolierenden Schicht eine elektrische Kontaktierung zwischen den beiden Metallstrukturen erfolgt.

Die zweite Metallstruktur ist bevorzugt eine Leiterbahnstruktur.

Bevorzugt werden zur Kontaktierung die Kontaktzonen mindestens einer Metallstruktur durch die isolierende Schicht hindurchgedrückt.

Vorteilhaft ist es, wenn beide Metallstrukturen einander zugewandte, aus der Ebene der jeweiligen Metallstruktur herausragende, Kontaktzonen aufweisen, die miteinander verbunden werden.

Eine der Metallstrukturen ist mit Vorteil selbsttragend ausgebildet.

Es ist möglich, dass eine der Metallstrukturen durch Kontaktierungsstellen eines elektronischen Bauelementes gebildet wird.

Besonders bevorzugt ist es, wenn eine Metallstruktur mit einer geschlossenen isolierenden Schicht laminiert wird und dass dabei die Kontaktzonen mindestens einer der Metallstrukturen durch die isolierende Schicht hindurchgedrückt werden.

Das Laminieren erfolgt vorteilhaft unter einem Druck von etwa 1,5 bis 3 bar und bei einer Temperatur von etwa 120 - 180°C.

In vorteilhafter Weise kann die mindestens eine Metallkontaktfläche nachgeprägt werden, um den Profilverlauf zu verstärken und somit zu verbessern.

Bei der Metallfolie handelt es sich bevorzugt um Kupferfolie. Geeignete Kunststofffolien (Transferfolien) sind dem Fachmann bekannt, z.B. Polyacrylfolie.

Ein nach dem vorliegenden Verfahren kontaktiertes Laminat findet Verwendung z. B. als Halbleiterträger, IC-Gehäuseteil, laminierter Connector, Schleifer, Bürste, Verbinder (Flip Chip), Sensor oder ähnlich ausgestaltete, andere elektrotechnische Kontakteinrichtung.

Im folgenden wird die Erfindung anhand von Abbildungen näher erläutert, ohne sie darauf zu beschränken:
- Fig. 1: zeigt die Draufsicht einer geprägten Kontaktstruktur,
- Fig. 2: zeigt die beiden Teilstrukturen im Querschnitt vor dem Zusammenfügen,
- Fig. 3: zeigt entsprechend die zusammengefügte Struktur,
- Fig. 4: zeigt die beiden Strukturen vor dem Zusammenfügen,
- Fig. 5: zeigt die Möglichkeit, den Kontakt durch Prägen von zwei gegenüberliegenden Seiten aus herzustellen,
- Fig. 6: zeigt die Verhältnisse, wenn die Metallstruktur eine Systemträger ist,
- Fig. 7: zeigt die beiden Teilstrukturen im Querschnitt vor dem Zusammenfügen,
- Fig. 8: zeigt entsprechend die zusammengefügte Struktur,
- Fig. 9: zeigt die beiden Strukturen vor dem Zusammenfügen,
- Fig. 10: zeigt die Möglichkeit, den Kontakt durch Prägen von zwei gegenüberliegenden Seiten aus herzustellen,
- Fig. 11: und 12 zeigen die Kontaktierung des Laminats mit einem elektronischen Bauteil und
- Fig. 13: zeigt die kontaktierte Vorrichtung im Querschnitt.

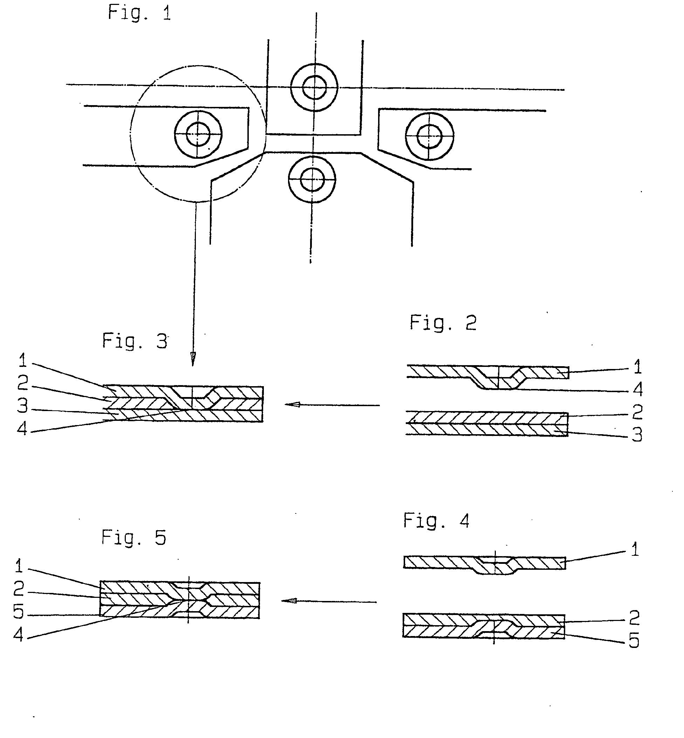

Fig. 1 zeigt die Draufsicht von Leiterbahnen mit geprägten Metallstrukturen, Fig. 2 die beiden Teilstrukturen im Querschnitt vor dem Zusammenfügen und Fig. 3 entsprechend die zusammengefügte Struktur, bei der ein Kontakt von **1** nach **3** ausgebildet ist, wobei **3** eine zweite Metallstruktur ohne Prägung bezeichnet. Die Ziffer **2** bezeichnet die Transferfolie. Diese kann strukturiert oder unstrukturiert sein. Die Ziffer **4** bezeichnet die Stelle, an welcher der Kontakt geschlossen werden kann, gegebenenfalls durch geeignete Maßnahmen wie Schweißen, Löten, Druck, Crimpen, Nieten, Bonden, Sintern, Reaktionsschweißen oder Reaktionsfügen.

In Fig. 5 ist die Möglichkeit gezeigt, den Kontakt **4** durch Prägen von zwei gegenüberliegenden Seiten aus herzustellen. Ziffer 5 bezeichnet eine Metallstruktur ähnlich **3** in Fig. 1, mit dem Unterschied, dass sie von unten geprägt ist. Fig. 4 zeigt die beiden Strukturen vor dem Zusammenfügen.

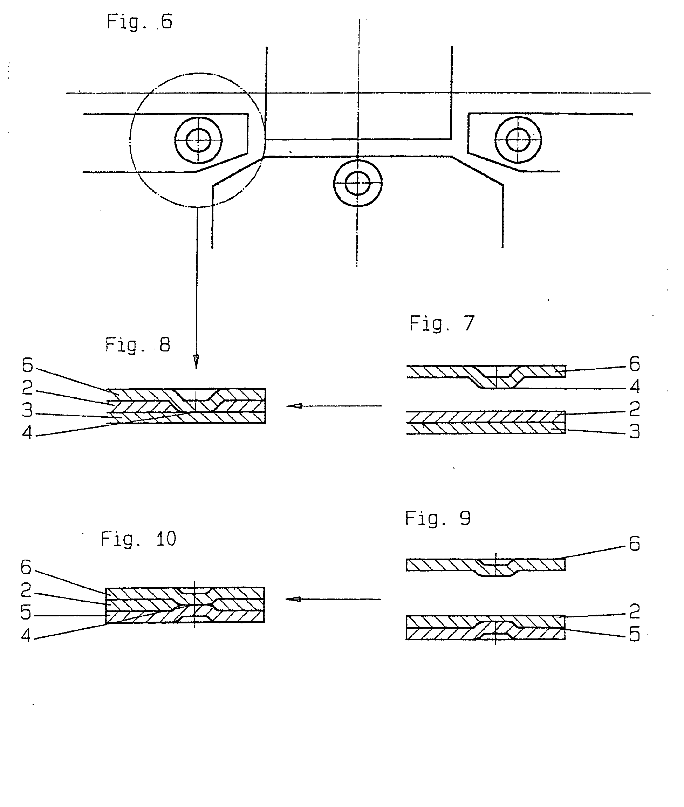

Fig. 6 zeigt die Verhältnisse, wenn die eine Metallstruktur ein Systemträger **6** ist. Fig. 7 zeigt die beiden Teilstrukturen im Querschnitt vor dem Zusammenfügen und Fig. 8 entsprechend die zusammengefügte Struktur, bei der ein Kontakt von 6 nach 3 ausgebildet ist.

In Fig. 10 ist wieder wie in Fig. 5 die Möglichkeit gezeigt, den Kontakt durch Prägen von zwei gegenüberliegenden Seiten aus herzustellen. Fig. 9 zeigt die beiden Strukturen vor dem Zusammenfügen.

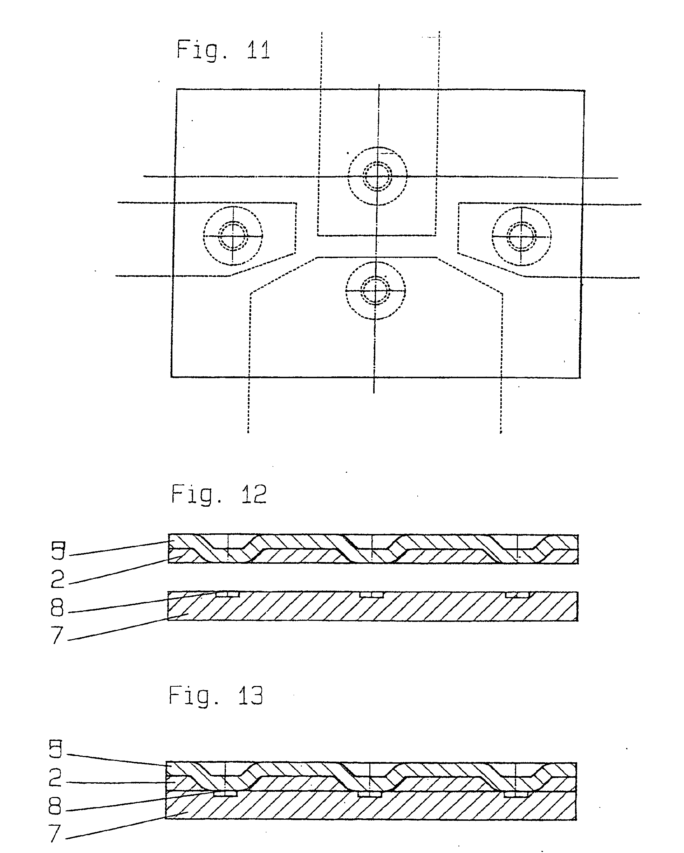

Die Figuren 11 und 12 zeigen die Kontaktierung des Laminats mit einem elektronischen Bauteil **7** an den dafür vorgesehen Kontaktstellen **8.** Die Ziffer 2 bezeichnet wieder die Transferfolie. Die Leiterbahnstruktur **9** ist an den Kontaktstellen frei von Kunststoff. Fig. 13 zeigt die kontaktierte Vorrichtung im Querschnitt.

## Patentansprüche

1. Verfahren zur elektrischen Kontaktierung zweier Metallstrukturen, wobei mindestens eine der Metallstrukturen auf ihrer der zweiten Metallstruktur zugewandten Seite aus einer Ebene herausragende Kontaktzonen aufweist, wobei zwischen den Metallstrukturen eine elektrisch isolierende Schicht angeordnet wird, wobei eine Metallstruktur mit der elektrisch isolierenden Schicht laminiert wird und danach oder gleichzeitig die zweite Metallstruktur mit der elektrisch isolierenden Schicht laminiert wird und wobei während des Laminierens der zweiten Metallstruktur mit der elektrisch isolierenden Schicht eine elektrische Kontaktierung zwischen den beiden Metallstrukturen erfolgt.

2. Verfahren nach Anspruch 1, **dadurch gekennzeichnet, dass** zur Kontaktierung die Kontaktzonen mindestens einer Metallstruktur durch die isolierende Schicht hindurchgedrückt werden.

3. Verfahren nach Anspruch 1 oder 2, **dadurch gekennzeichnet, dass** beide Metallstrukturen einander zugewandte aus der Ebene der jeweiligen Metallstruktur herausragende Kontaktzonen aufweisen, die miteinander verbunden werden.

4. Verfahren nach mindestens einem der Ansprüche 1 bis 3, **dadurch gekennzeichnet, dass** eine der Metallstrukturen selbsttragend ausgebildet wird.

5. Verfahren nach mindestens einem der Ansprüche 1 bis 3, **dadurch gekennzeichnet, dass** eine der Metallstrukturen als Kontaktierungsstellen eines elektronischen Bauelementes ausgebildet wird.

6. Verfahren nach mindestens einem der Ansprüche 1 bis 5, **dadurch gekennzeichnet, dass** eine Metallstruktur mit einer geschlossenen isolierenden Schicht laminiert wird und dass danach die Kontaktzonen mindestens einer der Metallstrukturen durch die isolierende Schicht hindurchgedrückt werden.

7. Verfahren nach mindestens einem der Ansprüche 1 bis 6, **dadurch gekennzeichnet, dass** das Laminieren unter einem Druck von etwa 1,5 bis 3 bar erfolgt.

8. Verfahren nach mindestens einem der Ansprüche 1 bis 7, **dadurch gekennzeichnet, dass** das Laminieren bei einer Temperatur von etwa 120 bis 180°C erfolgt.
